# EUROPEAN PATENT APPLICATION

(11) **EP 4 468 344 A1**
(43) Date of publication of application: **27.11.2024**
(21) Application number: 24175862.2
(22) Date of filing: 15.05.2024
(51) Int. Cl.: H01L 23/538, H01L 25/065, H01L 23/31

(54) **SEMICONDUCTOR PACKAGE STRUCTURE**

(30) Priority: 17.05.2023 US 202363502674 P; 06.03.2024 US 202418596830
(71) Applicant: MediaTek Inc., 30078 Hsinchu City (TW)
(72) Inventor: PENG, Tai-Hao, 30078 Hsinchu City (TW); JIANG, Yi-Che, 30078 Hsinchu City (TW); HUANG, Yao-Tsung, 30078 Hsinchu City (TW)
(74) Representative: Haseltine Lake Kempner LLP

(57) **Abstract**

A semiconductor package structure includes a redistribution layer, a first semiconductor die, a second semiconductor die, a molding material, and a dam structure. The redistribution layer has a first surface and a second surface opposite the first surface. The first semiconductor die and the second semiconductor die are disposed over the first surface of the redistribution layer. The molding material is arranged between the first semiconductor die and the second semiconductor die. The dam structure is disposed in the redistribution layer. The dam structure is arranged under the molding material between the first semiconductor die and the second semiconductor die.

## Description

This application claims the benefit of U.S. Provisional Application No. 63/502,674 filed on May 17, 2023, the entirety of which is incorporated by reference herein.

### BACKGROUND OF THE INVENTION

### Field of the Invention

The present invention relates to semiconductor technology, and, in particular, to a semiconductor package structure that includes a bridge structure.

### Description of the Related Art

In addition to providing a semiconductor die with protection from environmental contaminants, a semiconductor package structure can also provide an electrical connection between the semiconductor die packaged inside it and a substrate such as a printed circuit board (PCB).

Although existing semiconductor package structures generally meet requirements, they have not been satisfactory in some respects. For example, a thermal expansion mismatch between different materials may introduce stress, and high stress may cause cracks. This may cause the semiconductor package structures to fail. Therefore, further improvements in semiconductor package structures are required.

### BRIEF SUMMARY OF THE INVENTION

Semiconductor package structures are provided. An exemplary embodiment of a semiconductor package structure includes a redistribution layer, a first semiconductor die, a second semiconductor die, a molding material, and a dam structure. The redistribution layer has a first surface and a second surface opposite the first surface. The first semiconductor die and the second semiconductor die are disposed over the first surface of the redistribution layer. The molding material is arranged between the first semiconductor die and the second semiconductor die. The dam structure is disposed in the redistribution layer. The dam structure is arranged under the molding material between the first semiconductor die and the second semiconductor die.

Another embodiment of a semiconductor package structure includes a first redistribution layer, a bridge structure, a second redistribution layer, a first semiconductor die, a second semiconductor die, and a dam structure. The bridge structure is disposed over the first redistribution layer. The second redistribution layer is disposed over the bridge structure and electrically coupled to the bridge structure. The first semiconductor die and the second semiconductor die are disposed over the second redistribution layer. The first semiconductor die and the second semiconductor die partially vertically overlap the bridge structure. The dam structure is embedded in the second redistribution layer and vertically overlaps the bridge structure.

Yet another embodiment of a semiconductor package structure includes a bridge structure, a redistribution layer, a first semiconductor die, a second semiconductor die, a first molding material, and a dam structure. The redistribution layer is disposed over the bridge structure. The first semiconductor die and the second semiconductor die are disposed over the redistribution layer. The first semiconductor die is electrically coupled to the second semiconductor die through the first redistribution layer and the bridge structure. The first molding material surrounds the first semiconductor die and the second semiconductor die. The dam structure is disposed in the redistribution layer and between the first molding material and the bridge structure.

### BRIEF DESCRIPTION OF THE DRAWINGS

The present invention can be more fully understood by reading the subsequent detailed description and examples with references made to the accompanying drawings, wherein:
FIGs. 1A to 1F are cross-sectional views of various stages of manufacturing an exemplary semiconductor package structure in accordance with some embodiments of the present disclosure;
FIG. 2 is a cross-sectional view of an exemplary semiconductor package structure in accordance with some embodiments of the present disclosure;
FIG. 3 is a top view of an exemplary semiconductor package structure in accordance with some embodiments of the present disclosure;
FIG. 4A is a top view of a portion of an exemplary semiconductor package structure in accordance with some embodiments of the present disclosure;
FIG. 4B is a cross-sectional view of an exemplary semiconductor package structure in accordance with some embodiments of the present disclosure;
FIG. 5A is a top view of a portion of an exemplary semiconductor package structure in accordance with some embodiments of the present disclosure;
FIG. 5B is a cross-sectional view of an exemplary semiconductor package structure in accordance with some embodiments of the present disclosure;
FIG. 6A is a cross-sectional view of an exemplary dam structure in accordance with some embodiments of the present disclosure;
FIG. 6B is a cross-sectional view of an exemplary dam structure in accordance with some embodiments of the present disclosure;
FIG. 6C is a cross-sectional view of an exemplary dam structure in accordance with some embodiments of the present disclosure;
FIG. 7A is a top view of an exemplary dam structure in accordance with some embodiments of the present disclosure;
FIG. 7B is a top view of an exemplary dam structure in accordance with some embodiments of the present disclosure;
FIG. 7C is a top view of an exemplary dam structure in accordance with some embodiments of the present disclosure;
FIG. 7D is a top view of an exemplary dam structure in accordance with some embodiments of the present disclosure;
FIGs. 8A to 8E are cross-sectional views of various stages of manufacturing an exemplary semiconductor package structure in accordance with some embodiments of the present disclosure;
FIG. 9A is a cross-sectional view of an exemplary semiconductor package structure in accordance with some embodiments of the present disclosure;
FIG. 9B is a cross-sectional view of an exemplary semiconductor package structure in accordance with some embodiments of the present disclosure;
FIG. 9C is a cross-sectional view of an exemplary semiconductor package structure in accordance with some embodiments of the present disclosure; and
FIG. 9D is a cross-sectional view of an exemplary semiconductor package structure in accordance with some embodiments of the present disclosure.

### DETAILED DESCRIPTION OF THE INVENTION

The following description is made for the purpose of illustrating the general principles of the present disclosure and should not be taken in a limiting sense. The scope of the present disclosure is best determined by reference to the appended claims.

The present disclosure will be described with respect to particular embodiments and with reference to certain drawings, but the disclosure is not limited thereto and is only limited by the claims. The drawings described are only schematic and are non-limiting. In the drawings, the size of some of the elements may be exaggerated for illustrative purposes and not drawn to scale. The dimensions and the relative dimensions do not correspond to actual dimensions in the practice of the disclosure.

Additional elements may be added based on the embodiments described below. For example, the description of "a first element on/over a second element" may include embodiments in which the first element is in direct contact with the second element, and may also include embodiments in which additional elements are disposed between the first element and the second element such that the first element and the second element are not in direct contact.

Furthermore, the description of "a first element extending through a second element" may include embodiments in which the first element is disposed in the second element and extends from a side of the second element to an opposite side of the second element, wherein a surface of the first element may be substantially leveled with a surface of the second element, or a surface of the first element may be outside a surface of the second element.

The spatially relative descriptors of the first element and the second element may change as the structure is operated or used in different orientations. In addition, the present disclosure may repeat reference numerals and/or letters in the various embodiments. This repetition is for simplicity and clarity and does not in itself dictate a relationship between the various embodiments discussed.

A semiconductor package structure including a dam structure is described in accordance with some embodiments of the present disclosure. The dam structure is formed in a redistribution layer to resist cracks propagating into the redistribution layer, thereby avoiding failure.

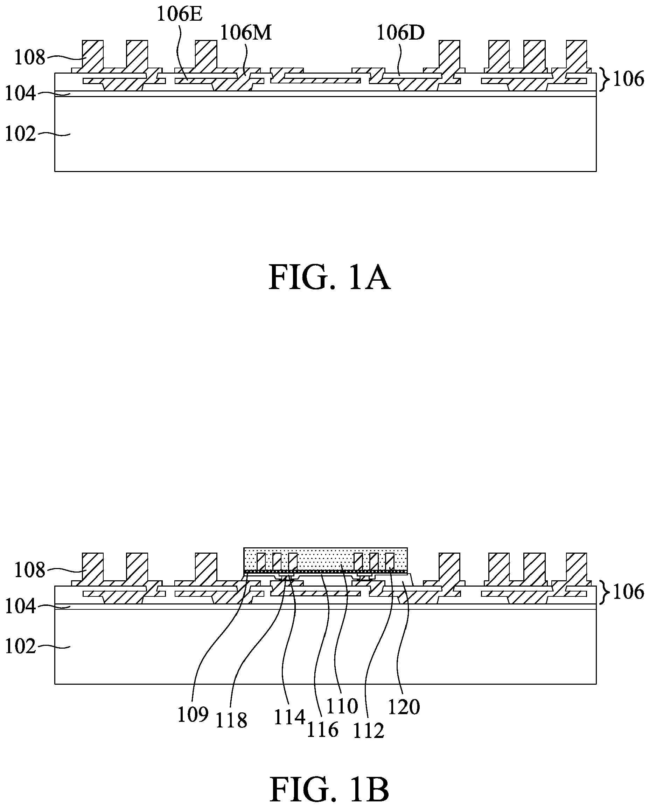

FIGs. 1A to 1F are cross-sectional views of various stages of manufacturing a semiconductor package structure 100 in accordance with some embodiments of the present disclosure. Additional features can be added to the semiconductor package structure 100. Some of the features described below can be replaced or eliminated for different embodiments. To simplify the diagram, only a portion of the semiconductor package structure 100 is illustrated.

As illustrated in FIG. 1A, a first redistribution layer 106 is formed over a carrier substrate 102 through a glue layer 104, in accordance with some embodiments. The carrier substrate 102 may be formed of silicon, glass, ceramic, or any suitable material. The glue layer 104 may be formed of a polymer-based material, and may be removed along with the carrier substrate 102 from the first redistribution layer 106. For example, the glue layer 104 may be formed of a material which loses its adhesive property when heated or exposed to UV lights.

The first redistribution layer 106 may include at least one metal layer and at least one dielectric layer 106D. A connecting structure 106M is disposed in the dielectric layer 106D and connected to a conductive wire 106E in the metal layer. The dielectric layer 106D may be formed of polymer, including polyimide (PI), polybenzoxazole (PBO), benzocyclobutene (BCB), epoxy, the like, or a combination thereof. Alternatively, the dielectric layer 106D may be formed of silicon oxide, silicon nitride, silicon oxynitride, the like, or a combination thereof. The dielectric layer 106D may be formed by spin coating, chemical vapor deposition (CVD), or another suitable deposition. Then, the dielectric layer 106D may be patterned.

The connecting structure 106M may be formed in the dielectric layers 106D by plating, CVD, physical vapor deposition (PVD), or another suitable deposition. The connecting structure 106M may be conductive vias, conductive trenches, conductive pads, or a combination thereof. The conductive vias or conductive trenches may electrically couple different levels of the conductive wires. A plurality of conductive pads are on the surface of the first redistribution layer 106 and electrically coupled to the conductive vias or conductive trenches. The connecting structure 106M may be formed of metal, such as tungsten, titanium, tantalum, ruthenium, cobalt, copper, aluminum, platinum, tin, silver, gold, the like, an alloy thereof, or a combination thereof.

Afterwards, a plurality of conductive pillars 108 are formed over the first redistribution layer 106 and electrically coupled to the conductive pads on the surface of the first redistribution layer 106, in accordance with some embodiments. The conductive pillars 108 may be formed of metal, such as tungsten, titanium, tantalum, ruthenium, cobalt, copper, aluminum, platinum, tin, silver, gold, the like, an alloy thereof, or a combination thereof. The conductive pillars 108 may be formed by plating, CVD, PVD, or another suitable deposition.

Then, as illustrated in FIG. 1B, a bridge structure 110 is formed over the first redistribution layer 106, in accordance with some embodiments. The bridge structure 110 may be a bridge die. The bridge structure 110 may include a silicon body and a redistribution layer 109 formed on the silicon body. The redistribution layer 109 may include a connecting structure in one or more dielectric layers and conductive wires, so that the redistribution layer 109 may electrically couple a plurality of semiconductor dies to each other, wherein the connecting structure may be vias. The sidewall of the redistribution layer 109 may be substantially coplanar with the sidewall of the silicon body.

The bridge structure 110 may include an interconnecting structure embedded in the silicon body, such as a plurality of through vias 112. The interconnecting structure in the bridge structure 110 may have other configurations. The through vias 112 may be formed of metal, such as tungsten, titanium, tantalum, ruthenium, cobalt, copper, aluminum, platinum, tin, silver, gold, the like, an alloy thereof, or a combination thereof.

A plurality of conductive pads 114 may be formed on the frontside surface of the bridge structure 110 and on the redistribution layer 109. The conductive pads 114 may be electrically coupled to the through vias 112 through the redistribution layer 109. The conductive pads 114 may be formed of metal, such as tungsten, titanium, tantalum, ruthenium, cobalt, copper, aluminum, platinum, tin, silver, gold, the like, an alloy thereof, or a combination thereof.

A passivation layer 116 is formed on the frontside surface of the bridge structure 110 and on the redistribution layer 109, in accordance with some embodiments. The passivation layer 116 may cover edge portions of the conductive pads 114 and may partially expose the conductive pads 114. In some embodiments, the passivation layer 116 may include a polymer layer, which may be formed of polyimide (PI), polybenzoxazole (PBO), benzocyclobutene (BCB), epoxy, the like, or a combination thereof. Alternatively, the passivation layer 116 may include a dielectric layer, which may be formed of silicon oxide, silicon nitride, silicon oxynitride, the like, or a combination thereof.

The bridge structure 110 may be electrically coupled to the conductive pads on the surface of the first redistribution layer 106 through a plurality of conductive connectors 118. The conductive connectors 118 may include microbumps, controlled collapse chip connection (C4) bumps, solder balls, ball grid array (BGA) balls, the like, or a combination thereof. The conductive connectors 118 may be formed of metal, such as tungsten, titanium, tantalum, ruthenium, cobalt, copper, aluminum, platinum, tin, silver, gold, the like, an alloy thereof, or a combination thereof. The conductive connectors 118 may be partially surrounded by the passivation layer 116.

An underfill material 120 may be formed between the bridge structure 110 and the first redistribution layer 106, in accordance with some embodiments. The underfill material 120 may surround each of the conductive connectors 118 to provide structural support. The underfill material 120 may be formed of polymer, including epoxy, polyimide, polybenzoxazole (PBO), the like, or a combination thereof. The underfill material 120 may be dispensed with capillary force, and then may be cured through any suitable curing process.

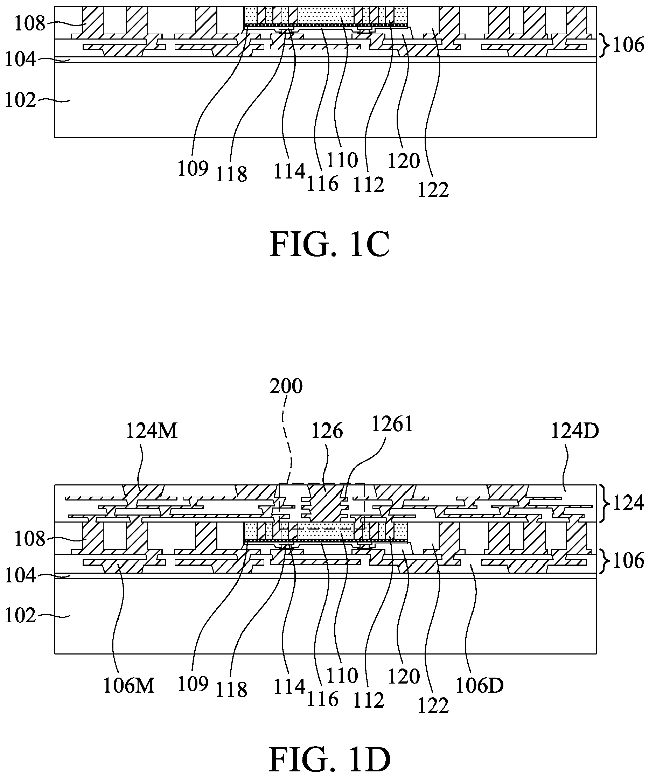

Then, as illustrated in FIG. 1C, a molding material 122 is formed over the first redistribution layer 106, in accordance with some embodiments. The molding material 122 may surround each of the conductive pillars 108 and the bridge structure 110. The molding material 122 may protect the conductive pillars 108 and the bridge structure 110 from the environment, thereby preventing them from damage due to stress, chemicals, and moisture. The molding material 122 may be formed of a non-conductive material, including moldable polymer, epoxy, resin, the like, or a combination thereof.

Afterwards, a planarization process is performed on the molding material 122 until the top surfaces of the conductive pillars 108 and the through vias 112 are exposed, in accordance with some embodiments. The planarization process may include a chemical mechanical polishing (CMP) process, a mechanical grinding process, the like, or a combination thereof. The top surface of the molding material 122, the top surfaces of the conductive pillars 108, the top surface of the bridge structure 110, and the top surfaces of the through vias 112 may be substantially coplanar.

Then, as illustrated in FIG. 1D, a second redistribution layer 124 is formed over the bridge structure 110, in accordance with some embodiments. The second redistribution layer 124 has a first surface and a second surface opposite the first surface. The first semiconductor die 128 and the second semiconductor die 138 are disposed over the first surface of the redistribution layer 124. The second redistribution layer 124 may include at least one metal layer and at least one dielectric layer 124D. At least one connecting structure 124M may be disposed in one or more dielectric layers 124D and may include conductive vias, conductive trenches, conductive pads, or a combination thereof. The precise patterns of the metal layer are defined using photolithography technology, metal plating, followed by an etching process to remove the excess metal, leaving the desired conductive wires and a conductive layer of the dam structure 126. The connecting structure 124M may be connected to a conductive wire in the metal layer or the conductive layer 1261 of the dam structure 126. The first redistribution layer 106 may be electrically coupled to the second redistribution layer 124 through the conductive pillars 108 and through the through vias 112.

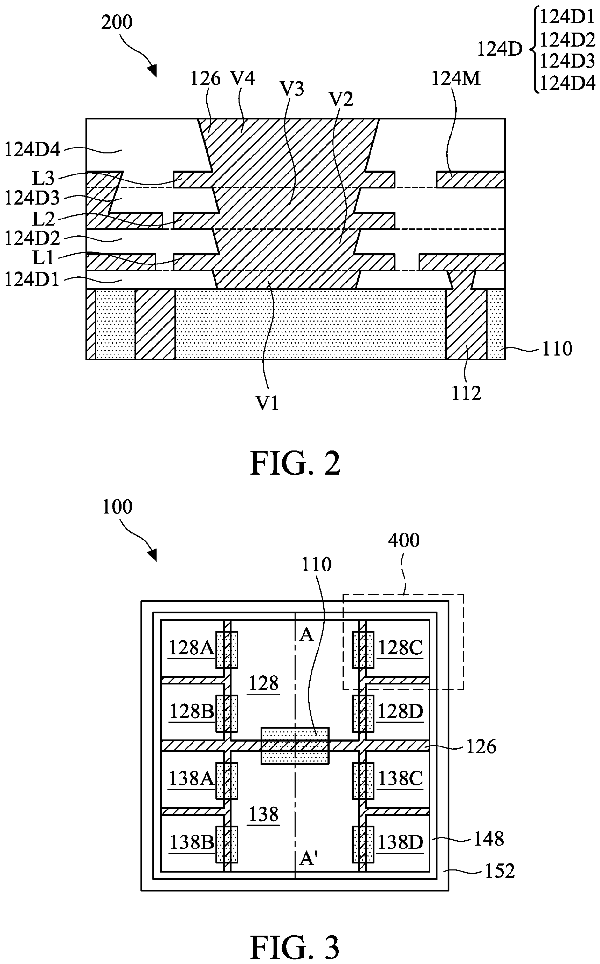

A dam structure 126 is formed in the second redistribution layer 124 during the formation of the second redistribution layer 124, in accordance with some embodiments. A portion 200 of the semiconductor package structure 100 which includes the dam structure 126 will be described with reference to FIG. 2.

FIG. 2 is a cross-sectional view of the portion 200 of the semiconductor package structure 100, in accordance with some embodiments of the disclosure. As illustrated in FIG. 2, the dam structure 126 may include a plurality of conductive layers L1, L2, L3 and a plurality of conductive vias V1, V2, V3, V4 stacked in an alternating manner.

A first dielectric layer 124D1 may be formed and then patterned. A first conductive via V1 may be formed in the first dielectric layer 124D1. A first conductive layer L1 may be formed over the first dielectric layer 124D 1 and may be connected to the first conductive via V1. Then, a second dielectric layer 124D2 may be formed and then patterned. A second conductive via V2 may be formed in the second dielectric layer 124D2 and may be connected to the first conductive layer L1. A second conductive layer L2 may be formed over the second dielectric layer 124D2 and may be connected to the second conductive via V2. Continue the above processes until the desired number of conductive layers is formed. With this arrangement, the dam structure 126 is formed.

The width of the conductive vias V1, V2, V3, and V4 may decrease in the direction toward the bridge structure 110. The conductive layers L1, L2, and L3 may vertically overlap the conductive vias V1, V2, V3, and V4. It should be noted that the number of conductive layers and the number of conductive vias are for illustrative purposes only. More conductive layers and conductive vias may be formed.

The material of the dam structure 126 may include metal, such as tungsten, titanium, tantalum, ruthenium, cobalt, copper, aluminum, platinum, tin, silver, gold, the like, an alloy thereof, or a combination thereof. The dam structure 126 may be formed during the formation of the second redistribution layer 124. The dam structure 126 and the connecting structure 124M and the conductive wire in the second redistribution layer 124 may include the same or similar material.

Referring back to FIG. 1D, the dam structure 126 may extend through the second redistribution layer 124. In particular, the dam structure 126 may extend from the first surface of the second redistribution layer 124 to the second surface of the second redistribution layer 124, wherein the second surface is opposite to the first surface. In particular, the top surface of the dam structure 126 may be exposed by the dielectric layers 124D, and the bottom surface of the dam structure 126 may be in contact with the bridge structure 110.

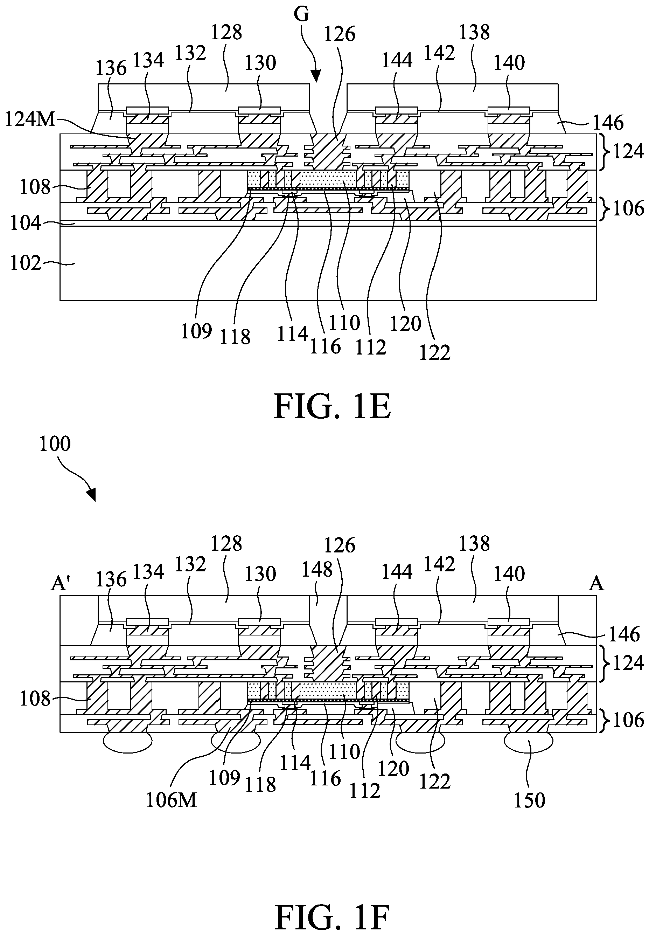

Then, as illustrated in FIG. 1E, a first semiconductor die 128 and a second semiconductor die 138 are formed over the second redistribution layer 124, in accordance with some embodiments. The first semiconductor die 128 and the second semiconductor die 138 may be arranged on opposite sides of the bridge structure 126. The first semiconductor die 128 and the second semiconductor die 138 may each partially overlap the bridge structure 126. The first semiconductor die 128 may be electrically coupled to the second semiconductor die 138 through the second redistribution layer 124, the through vias 112 and the redistribution layer 109 of the bridge structure 126.

In some embodiments, the first semiconductor die 128 and the second semiconductor die 138 each independently includes a system-on-chip (SoC) die, a logic device, a memory device, a radio frequency (RF) device, the like, or any combination thereof. For example, the first semiconductor die 128 and the second semiconductor die 138 may each include a micro control unit (MCU) die, a microprocessor unit (MPU) die, a power management integrated circuit (PMIC) die, a radio frequency front end (RFFE) die, an accelerated processing unit (APU) die, a central processing unit (CPU) die, a graphics processing unit (GPU) die, an input-output (IO) die, a dynamic random access memory (DRAM) controller, a static random-access memory (SRAM), a high bandwidth memory (HBM), an application processor (AP) die, an application specific integrated circuit (ASIC) die, the like, or any combination thereof.

The first semiconductor die 128 and the second semiconductor die 138 may include the same or different devices. For example, the first semiconductor die 128 and the second semiconductor die 138 may include SoC dies. Alternatively, the first semiconductor die 128 may include a SoC die, and the second semiconductor die 138 may include a HBM die. It should be noted that two semiconductor dies are for illustrative purposes only, more than two semiconductor dies and/or one or more passive components (such as resistors, capacitors, or inductors) may be disposed over the second redistribution layer 124.

A plurality of conductive pads 130 may be formed on the frontside of the first semiconductor die 128. A passivation layer 132 may be formed on the frontside of the first semiconductor die 128. The passivation layer 132 may cover edge portions of the conductive pads 130 and may partially expose the conductive pads 130. Similarly, a plurality of conductive pads 140 and a passivation layer 142 may be formed on the frontside of the second semiconductor die 138. The conductive pads 130, 140 and the passivation layer 132, 142 may be similar to the conductive pads 114 and the passivation layer 116, respectively, and will not be described in detail.

The first semiconductor die 128 and the second semiconductor die 138 may be electrically coupled to the connecting structure 124M through a plurality of conductive connectors 134 and 144, respectively. The conductive connectors 134 and 144 may include microbumps, controlled collapse chip connection (C4) bumps, solder balls, ball grid array (BGA) balls, the like, or a combination thereof. The conductive connectors 134 and 144 may be formed of metal.

An underfill material 136 is formed between the first semiconductor die 128 and the second redistribution layer 124, in accordance with some embodiments. The underfill material 136 may surround each of the conductive connectors 134 to provide structural support. In some embodiments, the underfill material 136 includes a non-conductive film. The first semiconductor die 128 may be bonded onto the second redistribution layer 124 by reflowing or any suitable bonding process.

Similarly, an underfill material 146 may be formed between the second semiconductor die 138 and the second redistribution layer 124. The underfill material 146 may be similar to the underfill material 136, and will not be described in detail. The underfill materials 136 and 146 may cover opposite sidewalls of the dam structure 126.

In comparison with an underfill material continuously extending below the first semiconductor die 128 and the second semiconductor die 138, the underfill material 136 and the underfill material 146 are discontinuous according to some embodiments of the present disclosure. In particular, the underfill material 136 may be spaced apart from the underfill material 146 by a gap G. The dam structure 126 may be disposed directly below the gap G. As a result, the stress coupling effect between the first semiconductor die 128 and the second semiconductor die 138 can be minimized or eliminated.

Then, as illustrated in FIG. 1F, a molding material 148 is formed over the second redistribution layer 124, in accordance with some embodiments. The molding material 148 may surround the underfill materials 136, 146, the first semiconductor die 128, and the second semiconductor die 138. The molding material 148 may protect these components from the environment, thereby preventing them from damage due to stress, chemicals, and moisture. The molding material 148 may extend into the gap G and may be in contact with the dam structure 126. The molding material 148 may be formed of a non-conductive material, including moldable polymer, epoxy, resin, the like, or a combination thereof.

Then, a planarization process may be performed on the molding material 148 until the top surfaces of the first semiconductor die 128 and the second semiconductor die 138 are exposed. The planarization process may include a CMP process, a mechanical grinding process, the like, or a combination thereof.

Afterwards, the carrier substrate 102 and the glue layer 104 may be removed by a de-bonding process. In some embodiments, the de-bonding is performed by projecting UV lights on the glue layer 104 or heating the glue layer 104, which causes the glue layer 104 to be decomposed, and hence the carrier substrate 102 is detached from the first redistribution layer 106.

Then, a plurality of conductive terminals 150 are formed below the first redistribution layer 106 and electrically coupled to the connecting structure 106M, in accordance with some embodiments. The conductive terminals 150 may include microbumps, controlled collapse chip connection (C4) bumps, solder balls, ball grid array (BGA) balls, the like, or a combination thereof. The conductive terminals 150 may be formed of metal, such as tungsten, titanium, tantalum, ruthenium, cobalt, copper, aluminum, platinum, tin, silver, gold, the like, an alloy thereof, or a combination thereof. A semiconductor package structure 100 is formed.

Because of thermal expansion mismatch, high stress zone may occur between semiconductor dies, and the high stress may cause cracks. According to some embodiments of the present disclosure, the dam structure 126 is disposed between the first semiconductor die 128 and the second semiconductor die 138, so that the stress can be reduced. In addition, the strength of the gap G between the first semiconductor die 128 and the second semiconductor die 138 can be enhanced.

Furthermore, the formation of the dam structure 126 can be integrated with the formation of the second redistribution layer 124. Thus, additional process is not required. The dam structure 126 can be compatible to any semiconductor package structure which includes a bridge structure.

FIG. 3 is a top view of the semiconductor package structure 100 of FIG. 1F, in accordance with some embodiments. FIG. 1F is a cross-sectional view of the semiconductor package structure 100 taken along line A-A' shown in FIG. 3.

As illustrated in FIG. 3, the semiconductor package structure 100 is formed over a substrate 152, in accordance with some embodiments. The substrate 152 may be a printed circuit board (PCB). The substrate 152 may include one or more layers of electrically-conductive traces. It should be noted that the configuration of the substrate 152 shown in the figures is exemplary only and is not intended to limit the present disclosure. Any desired semiconductor element may be formed in and on the substrate 152. However, in order to simplify the diagram, only the flat substrate 152 is illustrated.

The semiconductor package structure 100 may include semiconductor dies 128A, 128B, 128C, and 128D adjacent to the first semiconductor die 128 and semiconductor dies 138A, 138B, 138C, and 138D adjacent to the second semiconductor die 138. The semiconductor dies 128A, 128B, 128C, 128D, 138A, 138B, 138C, and 138D may include the components similar to the semiconductor dies 128 and 138, and will not be described in detail. The quantity of the semiconductor dies illustrated in FIG. 3 is an example, and other quantities of the semiconductor dies are within the scope of the present disclosure.

The semiconductor dies 128, 128A, 128B, 128C, 128D, 138, 138A, 138B, 138C, and 138D may be surrounded by the molding material 148. A plurality of bridge structures 110 may be formed between two of these semiconductor dies and may electrically couple two of these semiconductor dies.

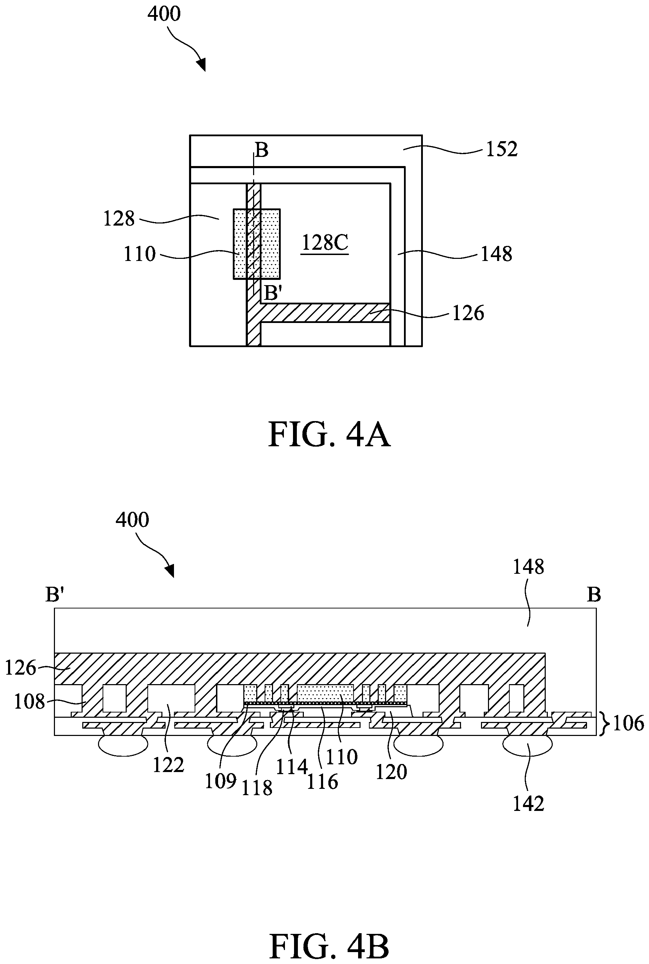

The dam structure 126 may be formed between two of these semiconductor dies. The dam structure 126 may partially surround each of the semiconductor dies 128, 128A, 128B, 128C, 128D, 138, 138A, 138B, 138C, 138D for minimizing or eliminating the stress coupling effect therebetween. A portion 400 of the semiconductor package structure 100 will be described with reference to FIGs. 4A and 4B.

FIG. 4A is a top view of the portion 400 of the semiconductor package structure 100, in accordance with some embodiments of the disclosure. As illustrated in FIG. 4A, a sidewall of the dam structure 126 is covered by the molding material 148, in accordance with some embodiments. In particular, the sidewall of the dam structure 126 may be substantially coplanar with the sidewalls of the semiconductor dies 128 and 128C.

FIG. 4B is a cross-sectional view of the portion 400 of the semiconductor package structure taken along line B-B' shown in FIG. 4A. The portion 400 of the semiconductor package structure in FIG. 4B may include the same or similar components as that of the semiconductor package structure 100 in FIG. 1F, and for the sake of simplicity, those components will not be discussed in detail again.

As illustrated in FIG. 4B, the molding material 148 may extend on the sidewall of the dam structure 126 and may be in contact with the molding material 122. In particular, the edge of the dam structure 126 may be enveloped by the molding materials 122 and 148. Since the molding material 122 and the molding material 148 may include the same material, an interface may not exist therebetween. The dam structure 126 may extend beyond the opposite sidewalls of the bridge structure 110, and may be disposed between the molding material 122 and the molding material 148.

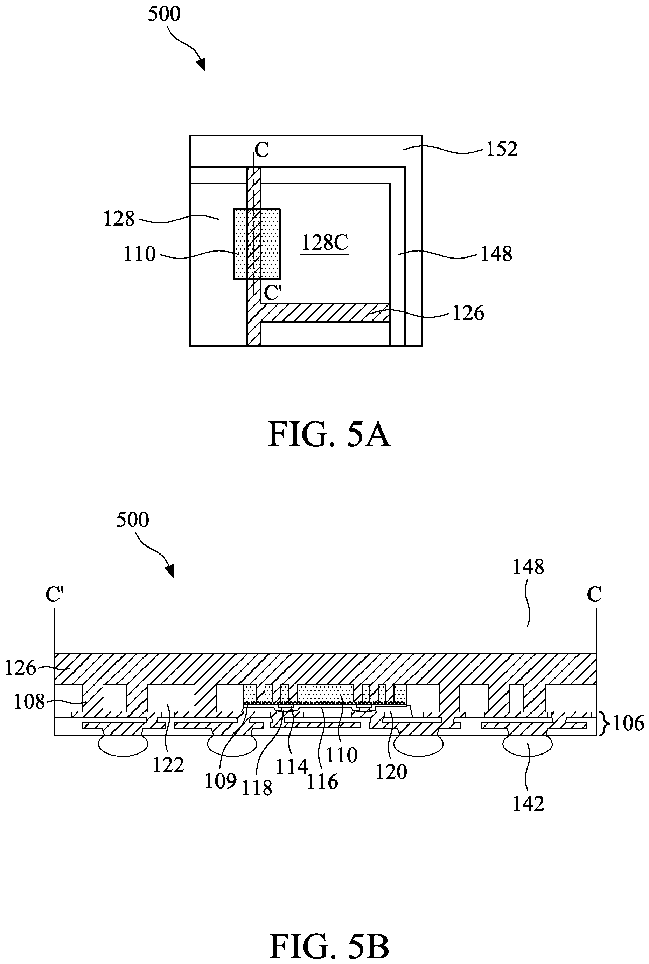

FIG. 5A is a top view of a portion 500 of a semiconductor package structure, in accordance with some embodiments of the disclosure. The portion 500 of the semiconductor package structure in FIG. 5A may include the same or similar components as that of the portion 400 of the semiconductor package structure in FIG. 4A, and for the sake of simplicity, those components will not be discussed in detail again. In the following embodiments, a sidewall of the dam structure 126 is exposed.

As illustrated in FIG. 5A, the dam structure 126 may extend beyond the sidewalls of the semiconductor dies 128 and 128C. In particular, the sidewall of the dam structure 126 may be substantially coplanar with the sidewall of the molding material 148.

FIG. 5B is a cross-sectional view of the portion 500 of the semiconductor package structure taken along line C-C' shown in FIG. 5A. The portion 500 of the semiconductor package structure in FIG. 5B may include the same or similar components as that of the portion 400 of the semiconductor package structure in FIG. 4B, and for the sake of simplicity, those components will not be discussed in detail again. As illustrated in FIG. 5B, the dam structure 126 may separate the molding material 122 and the molding material 148.

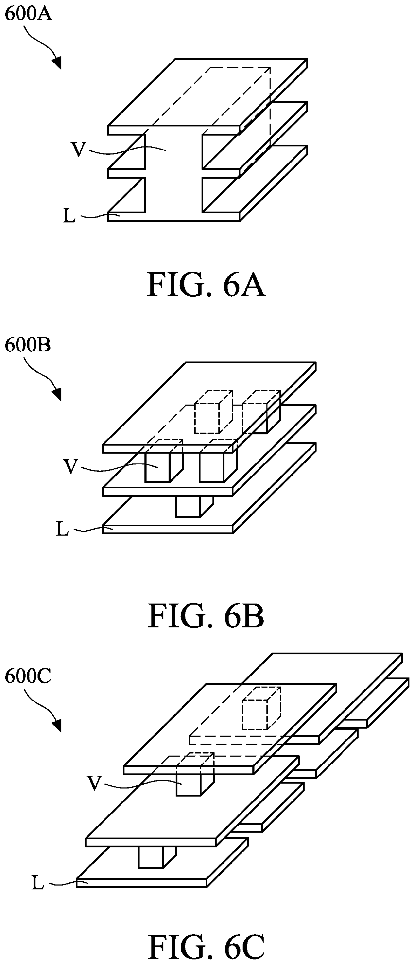

FIGs. 6A to 6C are cross-sectional views of dam structures 600A, 600B, and 600C in accordance with some embodiments of the present disclosure.

As shown in FIG. 6A, the dam structure 600A may include a plurality of conductive layers L and a plurality of conductive trenches V stacked in an alternating manner. The conductive trenches V may include strips, and may also be referred to as conductive strips. In particular, one dimension (such as the length) of the conductive trench V may be greater than another dimension (such as the width) of the conductive trench V in a direction that is substantially parallel to the top surface of the conductive layer L. Different levels of conductive trenches V may be arranged in columns. For example, different levels of conductive trenches V may substantially be aligned with each other.

As shown in FIG. 6B, the dam structure 600B may include a plurality of conductive layers L and a plurality of conductive vias V stacked in an alternating manner. Different levels of the conductive vias V may be staggered. The number of conductive vias V may be the same or different in different levels. In each level, one conductive layer L may connect two or more conductive vias V.

As shown in FIG. 6C, the dam structure 600C may include a plurality of conductive layers L and a plurality of conductive vias/trenches V stacked in an alternating manner. One or more conductive layers L may be discontinuous. In particular, at least one level of the conductive layers L may be separated into multiple segments. Different levels of the segments of the conductive layers L may be staggered, and may be connected by the conductive vias/trenches V. Different levels of the conductive vias/trenches V may be staggered. The number of segments of the conductive layers L may be the same or different in different levels, and the number of conductive vias/trenches V may be the same or different in different levels.

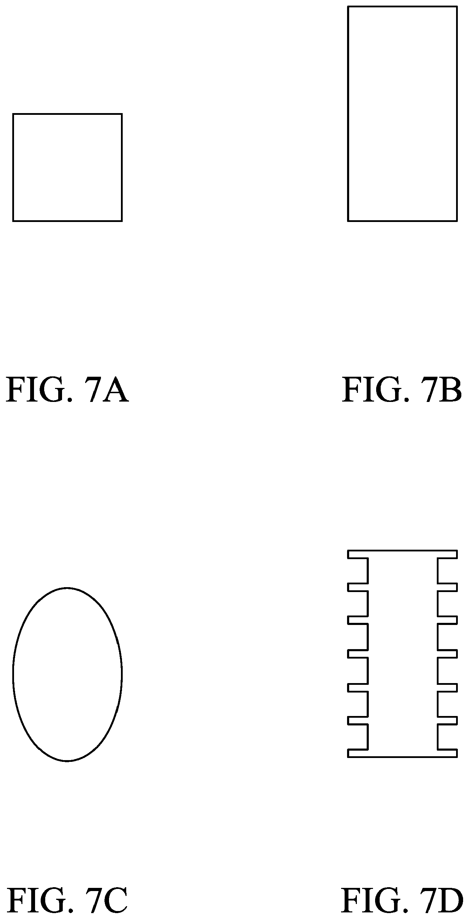

FIGs. 7A to 7D are top views of a surface of a conductive layer of a dam structure in accordance with some embodiments of the present disclosure. The surface of a conductive layer of a dam structure may include any suitable shape. For example, the surface of a conductive layer of a dam structure may include a quadrilateral, such as a square as illustrated in FIG. 7A, or a rectangle as illustrated in FIG. 7B. In another example, the surface of a conductive layer of a dam structure may be curved, such as an oval as illustrated in FIG. 7C. In another example, the surface of a conductive layer of a dam structure may include a repeating pattern, such as one or more I-shapes as illustrated in FIG. 7D.

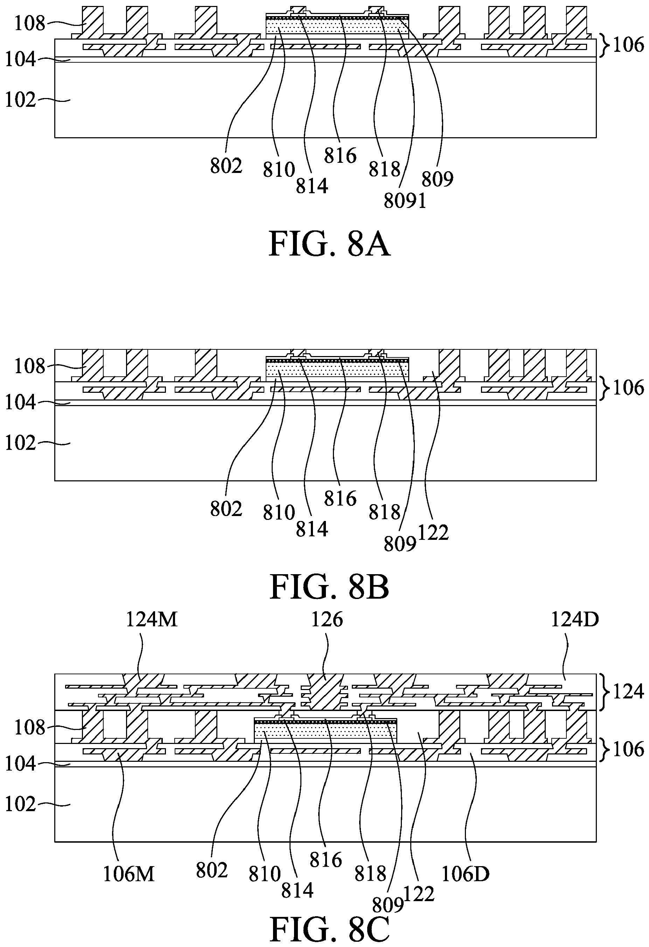

FIGs. 8A to 8E are cross-sectional views of various stages of manufacturing a semiconductor package structure 800 in accordance with some embodiments of the present disclosure.

FIG. 8A is subsequent to the step of the process that is illustrated in FIG. 1A, and the same or similar reference numbers are used to depict the same or similar components as those of the semiconductor package structure 100, so for the sake of simplicity, those components will not be discussed in detail again. In the following embodiments, through vias are not formed in a bridge structure.

As illustrated in FIG. 8A, the bridge structure 810 is formed over the first redistribution layer 106 with an adhesive layer 802, in accordance with some embodiments. The adhesive layer 802 may include an attaching film. In some embodiments, the adhesive layer 802 includes conductive paste (CP), non-conductive paste (NCP), high-k film, epoxy, any applicable materials, or a combination thereof.

The sidewall of the adhesive layer 802 may be substantially coplanar with the sidewall of the bridge structure 810. The adhesive layer 802 may be formed on the backside surface of the bridge structure 810.The conductive pads 814, the passivation layer 816, and the conductive connectors 818 may be formed on the frontside surface of the bridge structure 810. The bridge structure 810 may include a silicon body and a redistribution layer 809 formed on the silicon body. The redistribution layer 809 may include a connecting structure in one or more dielectric layers and conductive wires, so that the redistribution layer 809 may electrically couple a plurality of semiconductor dies to each other, wherein the connecting structure may be vias.

Then, as illustrated in FIG. 8B, the molding material 122 may be formed over the first redistribution layer 106. Afterwards, a planarization process may be performed on the molding material 122 until the top surfaces of the conductive pillars 108 and the conductive connectors 818 are exposed.

Then, as illustrated in FIG. 8C, the second redistribution layer 124 may be formed over the bridge structure 110. The second redistribution layer 124 may be electrically coupled to the bridge structure 110 through the conductive connectors 118.

The dam structure 126 may be embedded in the second redistribution layer 124. The dam structure 126 has been described above with reference to FIGs. 2 to 7D, and will not be repeated.

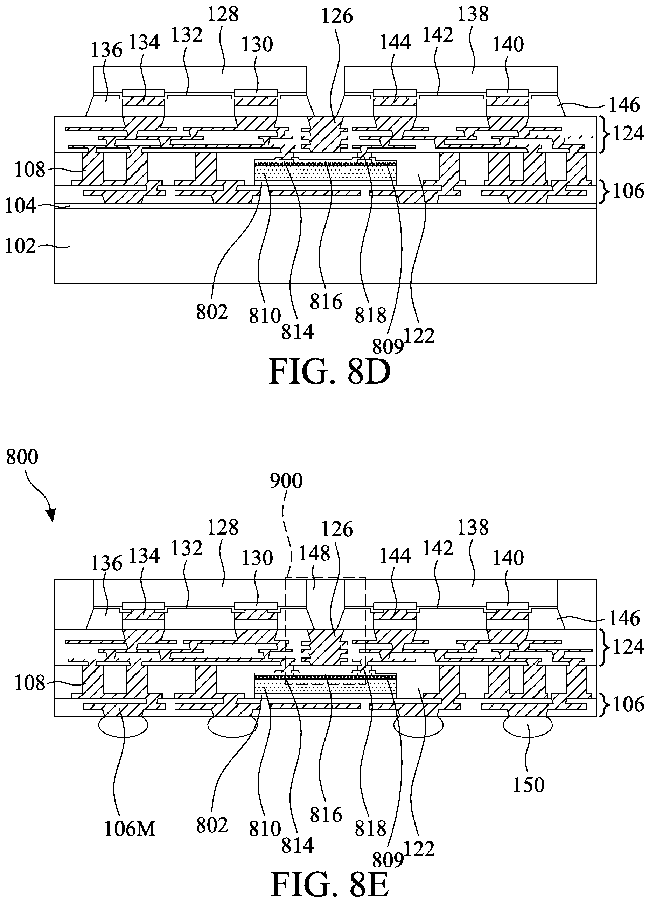

Then, as illustrated in FIG. 8D, the first semiconductor die 128 and the second semiconductor die 138 may be formed over the second redistribution layer 124. The conductive pads 130, the passivation layer 132, and the conductive connectors 134 may be formed on the frontside of the first semiconductor die 128, and the conductive pads 140, the passivation layer 142, and the conductive connectors 144 may be formed on the frontside of the second semiconductor die 138. The first semiconductor die 128 may be electrically coupled to the second semiconductor die 138 through the second redistribution layer 124, the conductive connectors 818 and the redistribution layer 809 of the bridge structure 810.

The top surface of the dam structure 126 may be exposed by the dielectric layers 124D, and the bottom surface of the dam structure 126 may be in contact with the molding material 122. The dam structure 126 may be spaced apart from the bridge structure 126 by the molding material 122.

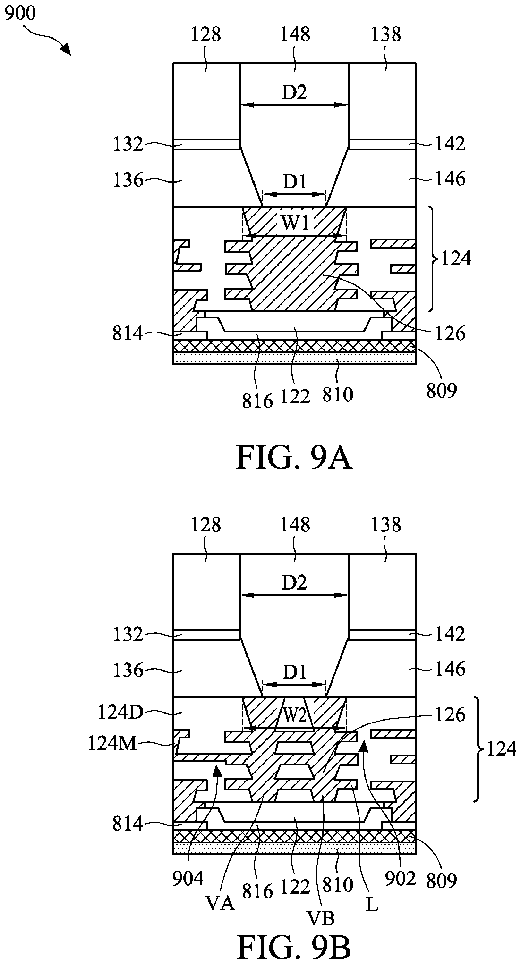

Afterwards, as illustrated in FIG. 8E, the molding material 148 may be formed over the second redistribution layer 124. Then, a planarization process may be performed on the molding material 148 until the top surfaces of the first semiconductor die 128 and the second semiconductor die 138 are exposed. Afterwards, the carrier substrate 102 and the glue layer 104 may be removed by a de-bonding process. Then, the conductive terminals 150 may be formed below the first redistribution layer 106 and electrically coupled to the connecting structure 106M. A portion 900 of the semiconductor package structure 800 will be described with reference to FIG. 9A.

FIG. 9A is a cross-sectional view of the portion 900 of the semiconductor package structure, in accordance with some embodiments of the disclosure. As illustrated in FIG. 9A, the underfill material 136 and the underfill material 146 may be spaced a distance D1 apart, wherein the distance D1 may be substantially equal to the width of the bottom surface of the molding material 148. The first semiconductor die 128 and the second semiconductor die 138 may be spaced a distance D2 apart. The distance D2 may be substantially equal to the width of the top surface of the molding material 148.

The distance D2 may be greater than distance D1. The bottom portion of the molding material 148 may be tapered. That is, the molding material 148 may have a tapered portion between the underfill material 136 and the underfill material 146. The width of the tapered portion of the molding material 148 may decrease in the direction toward the bridge structure 126.

The top surface of the dam structure 126 may be in contact with the taper portion of the molding material 148, and the bottom surface of the dam structure 126 may be in contact with the molding material 122. The top surface of the dam structure 126 may have a width W1. The width W1 may be greater than the distance D1. The width W1 may be greater than, equal to, or less than the distance D2.

FIG. 9A is provided as an example. Other examples may differ from what is described with regard to FIG. 9A. FIGs. 9B to 9D are cross-sectional views of portions of some exemplary semiconductor package structures, in accordance with some embodiments of the disclosure. The portions of the semiconductor package structures in FIGs. 9B to 9D may include the same or similar components as that of the portion 900 of the semiconductor package structure in FIG. 9A, and for the sake of simplicity, those components will not be discussed in detail again.

As shown in FIG. 9B, the dam structure 126 may have a plurality of conductive vias VA and VB arranged in more than one column. For example, this may be two columns. The dam structure 126 may have a plurality of conductive layers L connecting different columns of the conductive vias VA and VB. For example, one conductive layer L may connect two columns of the conductive vias VA and VB. In each column, different levels of the conductive vias may be substantially aligned with each other.

The underfill material 136 and the underfill material 146 may be spaced a distance D1 apart. The first semiconductor die 128 and the second semiconductor die 138 may be spaced a distance D2 apart. The top surface of the dam structure 126 may have a width of W2, which is equal to the sum of the width of the top surface of the columns of the conductive vias VA and VB and a space between the top surface of the columns of the conductive vias VA and VB. The width W2 may be greater than the distance D1. The width W2 may be greater than, equal to, or less than the distance D2.

The dam structure 126 may be spaced apart from the conductive wire, as indicated by the arrow 902. Alternatively, the dam structure 126 may be in contact with the conductive wire, as indicated by the arrow 904.

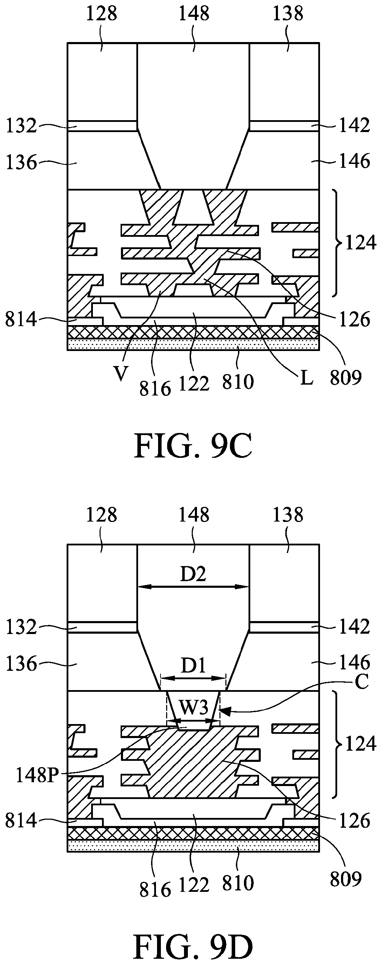

As illustrated in FIG. 9C, the dam structure 126 may have a plurality of conductive vias V. Different levels of conductive vias V are staggered. The number of conductive vias V may be the same or different in different levels. The dam structure 126 may have a plurality of conductive layers L connecting the conductive vias V in each level. As discussed above, the dam structure 126 may be spaced apart from the conductive wire, or may be in contact with the conductive wire of the second redistribution layer 124.

As shown in FIG. 9D, a cavity C may be formed in the second redistribution layer 124. The dam structure 126 may be disposed under the cavity C. The molding material 148 may have a protrusion 148P extending into the cavity C. In particular, the molding material 148 may be partially embedded in the second redistribution layer 124. The protrusion 148P may be tapered, and may have a maximum width W3 at the top surface of the second redistribution layer 124. The width of the protrusion 148P may decrease in the direction toward the bridge structure 110.

In some embodiments, the cavity C extends into the dam structure 126, and the molding material 148 is partially embedded in the dam structure 126, as illustrated in FIG. 9D, but the present disclosure is not limited thereto. For example, in some other embodiments, the cavity C stops on the top surface of the dam structure 126, and the bottom surface of the molding material 148 is substantially coplanar with the top surface of the dam structure 126.

Although the embodiments of FIGs. 9A to 9D are described with reference to the semiconductor package structure 800 as illustrated in FIG. 8E, the embodiments of FIGs. 9A to 9D can also be applied to other semiconductor package structures, including the semiconductor package structure 100 as illustrated in FIG. 1F and its related embodiments. Similarly, although the embodiments of FIGs. 2 to 7D are described with reference to the semiconductor package structure 100 as illustrated in FIG. 1F, the embodiments of FIGs. 2 to 7D can also be applied to other semiconductor package structures, including the semiconductor package structure 800 as illustrated in FIG. 8E and its related embodiments.

In summary, the semiconductor package structure according to the present disclosure includes a dam structure disposed between semiconductor dies, so that the stress due to thermal expansion mismatch can be reduced. The strength of between the semiconductor dies can be enhanced as well. Furthermore, the dam structure is embedded in a redistribution layer, and the formation of the dam structure can be integrated with the formation of the redistribution layer. Thus, additional process is not required.

According to some embodiments, underfill materials under the semiconductor dies are discontinuous. As a result, the stress coupling effect between the semiconductor dies can be minimized or eliminated.

While the invention has been described by way of example and in terms of the preferred embodiments, it should be understood that the invention is not limited to the disclosed embodiments. On the contrary, it is intended to cover various modifications and similar arrangements (as would be apparent to those skilled in the art). Therefore, the scope of the appended claims should be accorded the broadest interpretation so as to encompass all such modifications and similar arrangements.

The present invention may also be defined by the following numbered clauses.
1. A semiconductor package structure, comprising:
   a redistribution layer having a first surface and a second surface opposite the first surface;
   a first semiconductor die and a second semiconductor die, wherein the first semiconductor die and the second semiconductor die are disposed over the first surface of the redistribution layer;
   a molding material disposed between the first semiconductor die and the second semiconductor die; and
   a dam structure disposed in the redistribution layer, wherein the dam structure is arranged under the molding material between the first semiconductor die and the second semiconductor die.
2. The semiconductor package structure as claimed in clause 1, further comprising:
   a bridge structure disposed under the dam structure, wherein the first semiconductor die is electrically coupled to the second semiconductor die through the bridge structure and the redistribution layer.
3. The semiconductor package structure as claimed in clause 1, wherein the dam structure is arranged to extend from the first surface of the redistribution layer to the second surface of the redistribution layer, and a bottom surface of the molding material is or is not in contact with a top surface of the dam structure.
4. The semiconductor package structure as claimed in clause 3, wherein a width of the top surface of the dam structure is greater than a width of the bottom surface of the molding material.
5. The semiconductor package structure as claimed in clause 4, wherein a width of a top surface of the molding material is greater than the width of the bottom surface of the molding material.
6. The semiconductor package structure as claimed in clause 1, wherein the molding material extends into a cavity of the redistribution layer.
7. The semiconductor package structure as claimed in clause 6, wherein the molding material extends below a top surface of the dam structure.
8. The semiconductor package structure as claimed in clause 6, wherein a width of the molding material over the cavity is greater than a width of the molding material in the cavity.
9. The semiconductor package structure as claimed in clause 1, wherein the dam structure comprises a plurality of conductive layers, and the dam structure further comprises a plurality of conductive vias or a plurality of conductive strips that are stacked in an alternating manner with the plurality of conductive layers.
10. The semiconductor package structure as claimed in clause 9, wherein different levels of the conductive vias or the conductive strips are staggered.
11. The semiconductor package structure as claimed in clause 9, wherein the conductive vias or the conductive strips are arranged in more than one column.
12. The semiconductor package structure as claimed in clause 9, wherein a shape of a surface of the conductive layer is a square, a rectangle, an oval, or one or more I-shapes.
13. The semiconductor package structure as claimed in clause 9, wherein at least one level of the conductive layers is separated into multiple segments, and different levels of the segments of the conductive layers is staggered and connected by the conductive via or the conductive strip.
14. The semiconductor package structure as claimed in clause 9, wherein the redistribution layer comprises a conductive wire in contact with the conductive layers of the dam structure.
15. The semiconductor package structure as claimed in clause 9, wherein the redistribution layer comprises a conductive wire, and wherein the conductive wire and the conductive layers of the dam structure are spaced apart and disconnected.
16. The semiconductor package structure as claimed in clause 1, further comprising:
   a first underfill, arranged between the first surface of the redistribution layer and the first semiconductor die; and
   a second underfill, arranged between the first surface of the redistribution layer and the second semiconductor die;
   wherein a portion of the molding is arranged in a gap between the first underfill and the second underfill.
17. A semiconductor package structure, comprising:
   a first redistribution layer;
   a bridge structure disposed over the first redistribution layer;
   a second redistribution layer disposed over the bridge structure and electrically coupled to the bridge structure;
   a first semiconductor die and a second semiconductor die, wherein the first semiconductor die and the second semiconductor die are disposed over the second redistribution layer, and the first semiconductor die and the second semiconductor die partially vertically overlap the bridge structure; and
   a dam structure embedded in the second redistribution layer and vertically overlapping the bridge structure.
8. A semiconductor package structure, comprising:
   a bridge structure;
   a redistribution layer disposed over the bridge structure;
   a first semiconductor die and a second semiconductor die, wherein the first semiconductor die and the second semiconductor die are disposed over the redistribution layer, wherein the first semiconductor die is electrically coupled to the second semiconductor die through the first redistribution layer and the bridge structure;
   a first molding material surrounding the first semiconductor die and the second semiconductor die; and
   a dam structure disposed in the redistribution layer and between the first molding material and the bridge structure.
19. The semiconductor package structure as claimed in clause 18, wherein the dam structure is in contact with the bridge structure.
20. The semiconductor package structure as claimed in clause 18, further comprising a second molding material surrounding the bridge structure and in contact with the dam structure.
21. The semiconductor package structure as claimed in clause 18, wherein the first molding material extends on a sidewall of the dam structure.
22. The semiconductor package structure as claimed in clause 18, wherein the first molding material comprises a protrusion embedded in the redistribution layer, and wherein the protrusion has a width that decreases in a direction toward the bridge structure.

## Claims

1. A semiconductor package structure (100, 800), comprising:
a redistribution layer (124) having a first surface and a second surface opposite the first surface;
a first semiconductor die (128) and a second semiconductor die (138), wherein the first semiconductor die (128) and the second semiconductor die (138) are disposed over the first surface of the redistribution layer (124);
a molding material (148) disposed between the first semiconductor die (128) and the second semiconductor die (138); and
a dam structure (126, 600A, 600B, 600C) disposed in the redistribution layer (124), wherein the dam structure (126, 600A, 600B, 600C) is arranged under the molding material (148) between the first semiconductor die (128) and the second semiconductor die (138).

2. The semiconductor package structure (100, 800) as claimed in claim 1, further comprising:
a bridge structure (110, 810) disposed under the dam structure (126, 600A, 600B, 600C), wherein the first semiconductor die (128) is electrically coupled to the second semiconductor die (138) through the bridge structure (110, 810) and the redistribution layer (124).

3. The semiconductor package structure (100, 800) as claimed in claim 1, wherein the dam structure (126, 600A, 600B, 600C) is arranged to extend from the first surface of the redistribution layer (124) to the second surface of the redistribution layer (124), and a bottom surface of the molding material (148) is or is not in contact with a top surface of the dam structure (126, 600A, 600B, 600C).

4. The semiconductor package structure (100, 800) as claimed in claim 3, wherein a width of the top surface of the dam structure (126, 600A, 600B, 600C) is greater than a width of the bottom surface of the molding material (148).

5. The semiconductor package structure (100, 800) as claimed in claim 4, wherein a width of a top surface of the molding material (148) is greater than the width of the bottom surface of the molding material (148).

6. The semiconductor package structure (100, 800) as claimed in claim 1, wherein the molding material (148) extends into a cavity of the redistribution layer (124).

7. The semiconductor package structure (100, 800) as claimed in claim 6, wherein the molding material (148) extends below a top surface of the dam structure (126, 600A, 600B, 600C); or
wherein a width of the molding material (148) over the cavity is greater than a width of the molding material (148) in the cavity.

8. The semiconductor package structure (100, 800) as claimed in claim 1, wherein the dam structure (126, 600A, 600B, 600C) comprises a plurality of conductive layers, and the dam structure (126, 600A, 600B, 600C) further comprises a plurality of conductive vias (V) or a plurality of conductive strips that are stacked in an alternating manner with the plurality of conductive layers.

9. The semiconductor package structure (100, 800) as claimed in claim 8, wherein different levels of the conductive vias (V) or the conductive strips are staggered; or
wherein the conductive vias (V) or the conductive strips are arranged in more than one column; or
wherein at least one level of the conductive layers is separated into multiple segments, and different levels of the segments of the conductive layers is staggered and connected by the conductive via or the conductive strip.

10. The semiconductor package structure (100, 800) as claimed in claim 8, wherein the redistribution layer (124) comprises a conductive wire (106E) in contact with the conductive layers of the dam structure (126, 600A, 600B, 600C); or
wherein the redistribution layer (124) comprises a conductive wire (106E), and wherein the conductive wire (106E) and the conductive layers of the dam structure (126, 600A, 600B, 600C) are spaced apart and disconnected.

11. The semiconductor package structure (100, 800) as claimed in claim 1, further comprising:
a first underfill (136), arranged between the first surface of the redistribution layer (124) and the first semiconductor die (128); and
a second underfill (146), arranged between the first surface of the redistribution layer (124) and the second semiconductor die (138);
wherein a portion of the molding material (148) is arranged in a gap between the first underfill and the second underfill.

12. A semiconductor package structure (100, 800), comprising:
a first redistribution layer (106);
a bridge structure (110, 810) disposed over the first redistribution layer (106);
a second redistribution layer (124) disposed over the bridge structure (110, 810) and electrically coupled to the bridge structure (110, 810);
a first semiconductor die (128) and a second semiconductor die (138), wherein the first semiconductor die (128) and the second semiconductor die (138) are disposed over the second redistribution layer (124), and the first semiconductor die (128) and the second semiconductor die (138) partially vertically overlap the bridge structure (110, 810); and
a dam structure (126, 600A, 600B, 600C) embedded in the second redistribution layer (124) and vertically overlapping the bridge structure (110, 810).

13. A semiconductor package structure (100, 800), comprising:
a bridge structure (110, 810);
a redistribution layer (124) disposed over the bridge structure (110, 810);
a first semiconductor die (128) and a second semiconductor die (138), wherein the first semiconductor die (128) and the second semiconductor die (138) are disposed over the redistribution layer (124), wherein the first semiconductor die (128) is electrically coupled to the second semiconductor die (138) through the redistribution layer (124) and the bridge structure (110, 810);
a first molding material (148) surrounding the first semiconductor die (128) and the second semiconductor die (138); and
a dam structure (126, 600A, 600B, 600C) disposed in the redistribution layer (124) and between the first molding material (148) and the bridge structure (110, 810).

14. The semiconductor package structure (100, 800) as claimed in claim 13, wherein the dam structure (126, 600A, 600B, 600C) is in contact with the bridge structure (110, 810); or
wherein the semiconductor package further comprises a second molding material (122) surrounding the bridge structure (110, 810) and in contact with the dam structure (126, 600A, 600B, 600C); or
wherein the first molding material (148) extends on a sidewall of the dam structure (126, 600A, 600B, 600C).

15. The semiconductor package structure (100, 800) as claimed in claim 13, wherein the first molding material (148) comprises a protrusion (148P) embedded in the redistribution layer (124), and wherein the protrusion (148P) has a width that decreases in a direction toward the bridge structure (110, 810).
